# EUROPEAN PATENT SPECIFICATION

(11) **EP 3 051 930 B1**
(45) Date of publication and mention of the grant of the patent: **28.06.2017**
(21) Application number: 15153407.0
(22) Date of filing: 02.02.2015
(51) Int. Cl.: H05K 7/14

(54) **Slide rail assembly**
Schienenanordnung
Ensemble de rail de glissement

(43) Date of publication of application: 03.08.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Weng, Cheng-Chieh, Kaohsiung City (TW); Wang, Chun-Chiang, Kaohsiung City (TW)
(74) Representative: Viering, Jentschura & Partner mbB Patent- und Rechtsanwälte

(56) References cited:
- US-A1- 2014 226 924
- US-B1- 6 685 033

## Description

### Field of the Invention

The present invention relates to a slide rail assembly and, more particularly, to a slide rail assembly which is applicable to and can easily pull apart at least two chassis.

### Background of the Invention

In a rack-based server system, the chassis of a server is typically mounted with slide rails on both lateral sides in order to be installed on the supporting posts of a rack via the slide rails and their brackets. The slide rails make it easy to pull the server out of the rack for inspection or maintenance. Related slide rail designs are already disclosed in US Patent Nos. 7,137,512 and 6,930,886, among others. Nowadays, the various components of a server are modularized to facilitate assembly, disassembly, and maintenance. For example, a main module is provided in a central portion of a server chassis while a hard disk module, a power supply module, and so on are provided at two opposite ends of the chassis. The modules are connected to one another by cables. To detach a certain module (e.g., a hard disk module), cables between the related modules must be disconnected first, which, however, often presents difficulties due to the complexity of the cables, and the limited space, in the chassis, and maintenance is inconvenienced as a result.

US 6,685,033 B1 discloses a system and apparatus for enabling top, front and rear access to a rack mounted computer device. The rack structure comprises a pair of rails attached to opposite sides of the computer device. The slide assemblies and the rails cooperate with each other to allow the computer device to be extended from a front opening and a rear opening of the rack structure.

US 2014/0226924 A1 discloses slide assemblies including an inner slide segment and an outer slide segment. The inner slide segment includes a plurality of rollers separated into an upper row and a lower row and a plurality of keyholes separated into pairs, each of which includes an upper keyhole and a lower keyhole.

### Summary of the Invention

The present invention relates to a slide rail assembly applicable to at least two chassis.

According to one aspect of the present invention, a slide rail assembly includes a first rail, a second rail, a third rail, and an extension rail. The second rail can be longitudinally displaced relative to the first rail. The second rail includes a first section and a second section. The third rail is movably connected to the first section of the second rail and can be longitudinally displaced relative to the first rail by the second rail. The extension rail is located at the second section of the second rail.

Preferably, the slide rail assembly further includes a supporting member connected to the third rail, and the supporting member has at least one engaging section for making engaging contact with the second rail.

Preferably, the second rail further includes a recess, the slide rail assembly further includes a supporting member connected to the third rail, and the supporting member has a pushing portion to be inserted into the recess. Preferably, the pushing portion of the supporting member has a side provided with at least one engaging section for making engaging contact with the recess.

Preferably, the supporting member further has a cushioning portion opposite the pushing portion, and the first rail further includes a rear blocking portion so that, when displaced to a retracted position relative to the first rail, the third rail is pressed against the rear blocking portion of the first rail via the cushioning portion of the supporting member.

Preferably, the first rail further includes a limiting feature so that, when the third rail has been displaced by the second rail to a first predetermined position relative to the first rail, the pushing portion of the supporting member is pressed against the limiting feature of the first rail and thereby retains the third rail at the first predetermined position.

Preferably, the slide rail assembly further includes a supporting member connected to the third rail, and the supporting member has a pair of supporting wings to be pressed against the first rail.

Preferably, the slide rail assembly further includes a base mounted to the first section of the second rail, and the third rail further includes a limiting feature so that, when the second rail has been displaced to a second predetermined position relative to the first rail, the base of the second rail is pressed against the limiting feature of the third rail and thereby retains the second rail at the second predetermined position.

Preferably, the slide rail assembly further includes an engaging member elastically mounted to the first section of the second rail, the engaging member includes at least one engaging projection, and the first rail further includes a front blocking portion. When the second rail has been pulled out relative to the first rail to a certain position, the engaging projection of the engaging member is engaged with the front blocking portion of the first rail.

Preferably, the slide rail assembly further includes an operating member connected to the engaging member, the first section of the second rail has an aperture, and the operating member has an operating portion located at the aperture. By operating the operating portion of the operating member, the engaging projection of the engaging member is disengaged from the first rail.

Preferably, at least one of the operating member and the engaging member further has an inclined projection so that, by operating the operating member, the inclined projection is driven to push the engaging member and thereby disengage the engaging member from the first rail.

Preferably, the slide rail assembly further includes a positioning element for mounting the extension rail to the second section of the second rail so that the second rail can be displaced relative to the first rail via the extension rail.

According to another aspect of the present invention, a slide rail assembly applicable to a first chassis and a second chassis includes a first rail, a second rail, and a third rail. The second rail can be longitudinally displaced relative to the first rail. The second rail includes a first section and a second section. The second section is connected with the second chassis. The second rail can be displaced relative to the first rail by the second chassis. The third rail is movably connected to the first section of the second rail and is mounted with the first chassis. The third rail can be longitudinally displaced relative to the first rail by the second rail.

Preferably, the slide rail assembly further includes an extension rail located at the second section of the second rail, and the second chassis is mounted to the extension rail.

One of the advantageous features of implementing the present invention is that a first chassis and a second chassis can be mounted to two rails of the slide rail assembly respectively.

### Brief Description of the Drawings

The invention as well as a preferred mode of use and the advantages thereof will be best understood by referring to the following detailed description of some illustrative embodiments in conjunction with the accompanying drawings, in which:
FIG. 1 is a schematic perspective view in which the slide rail assembly in an embodiment of the present invention has been pulled to an opened position along with two chassis;
FIG. 2 is a schematic perspective view in which the slide rail assembly in an embodiment of the present invention is in a retracted position;
FIG. 3 is a schematic exploded view of the slide rail assembly in an embodiment of the present invention;
FIG. 4 is a schematic exploded view of the second rail and the third rail of the slide rail assembly in an embodiment of the present invention;
FIG. 5 is a schematic plan view in which the slide rail assembly in an embodiment of the present invention is in a retracted position;
FIG. 6 is another schematic plan view of the slide rail assembly in FIG. 5, in which the third rail has been displaced to a first predetermined position along with the second rail;
FIG. 7 is yet another schematic plan view of the slide rail assembly in FIG. 5, in which the second rail is further displaced outward while the third rail stays at the first predetermined position;
FIG. 8 is still another schematic plan view of the slide rail assembly in FIG. 5, in which the second rail has been displaced to a second predetermined position relative to the first rail;
FIG. 9A is a schematic sectional view showing the second rail of the slide rail assembly in an embodiment of the present invention being displaced relative to the first rail, in which the engaging projection of the engaging member has been displaced to a position adjacent to the front blocking portion of the first rail;
FIG. 9B is another schematic sectional view of the first and the second rails in FIG. 9A, in which the engaging projection of the engaging member is pressed against the inclined surface of the front blocking portion of the first rail;
FIG. 9C is still another schematic sectional view of the first and the second rails in FIG. 9A, in which the engaging projection of the engaging member has moved past, and is engaged with, the front blocking portion of the first rail;
FIG. 10 is a schematic perspective view in which the slide rail assembly in an embodiment of the present invention is in an opened position where the slide rail assembly is extended to the greatest extent;
FIG. 11 is a schematic perspective view of the slide rail assembly in an embodiment of the present invention, in which the engaging projection of the engaging member is engaged with the front blocking portion of the first rail;
and
FIG. 12 is a schematic sectional view of the slide rail assembly in an embodiment of the present invention, showing how the engaging projection of the engaging member is disengaged from the front blocking portion of the first rail by operating the operating member.

### Detailed Description of the Invention

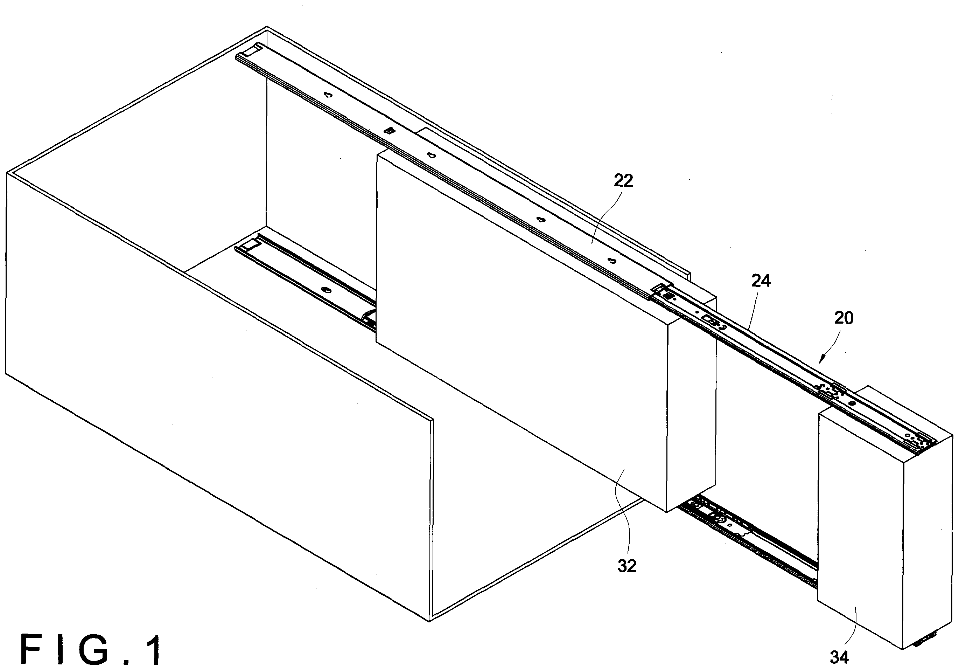

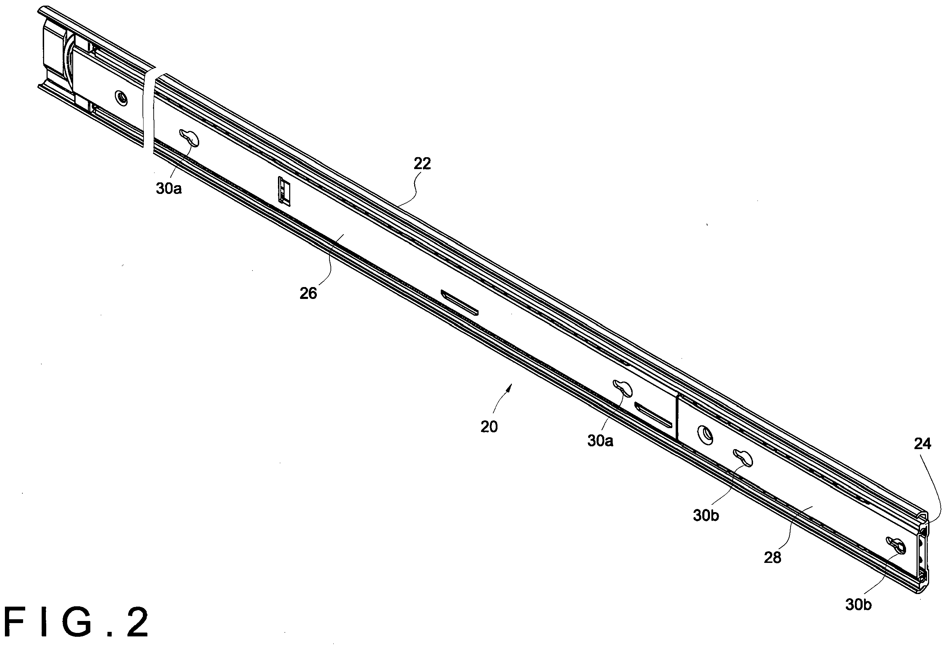

As shown in FIG. 1 and FIG. 2, the slide rail assembly 20 in an embodiment of the present invention is applicable to a server system. The slide rail assembly 20 includes a first rail 22, a second rail 24, a third rail 26, and an extension rail 28. The second rail 24 and the third rail 26 can be longitudinally displaced relative to the first rail 22. The third rail 26 has a plurality of mounting portions 30a. The extension rail 28 also has a plurality of mounting portions 30b. To apply the slide rail assembly 20 to the server system, a first chassis 32 (e.g., the chassis of a server) is mounted to the third rail 26 via the mounting portions 30a, and a second chassis 34 (e.g., the chassis of a storage device) is mounted to the extension rail 28 via the mounting portions 30b.

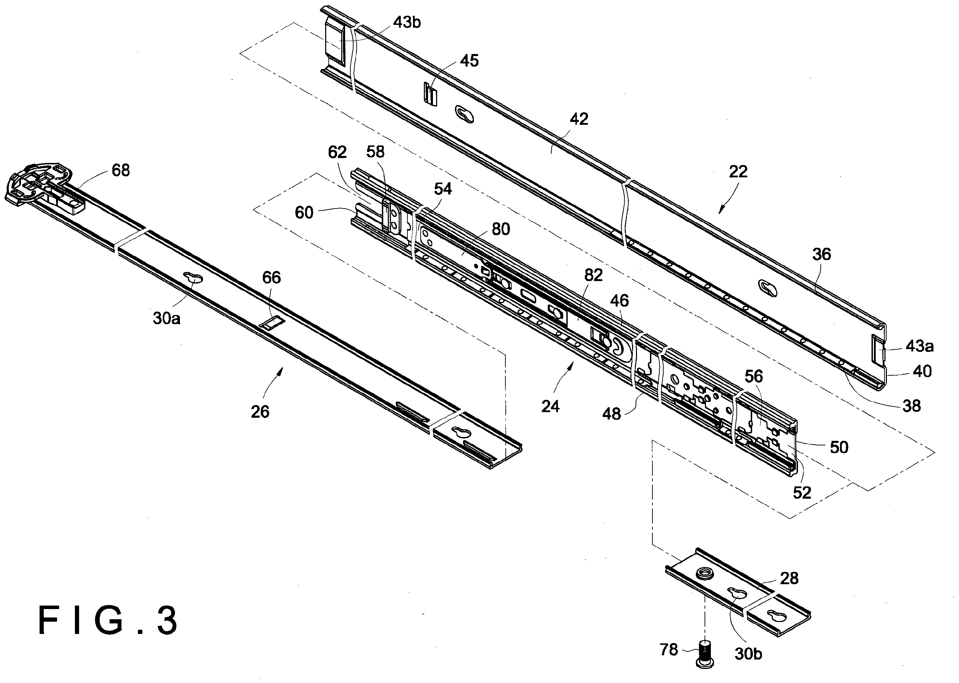

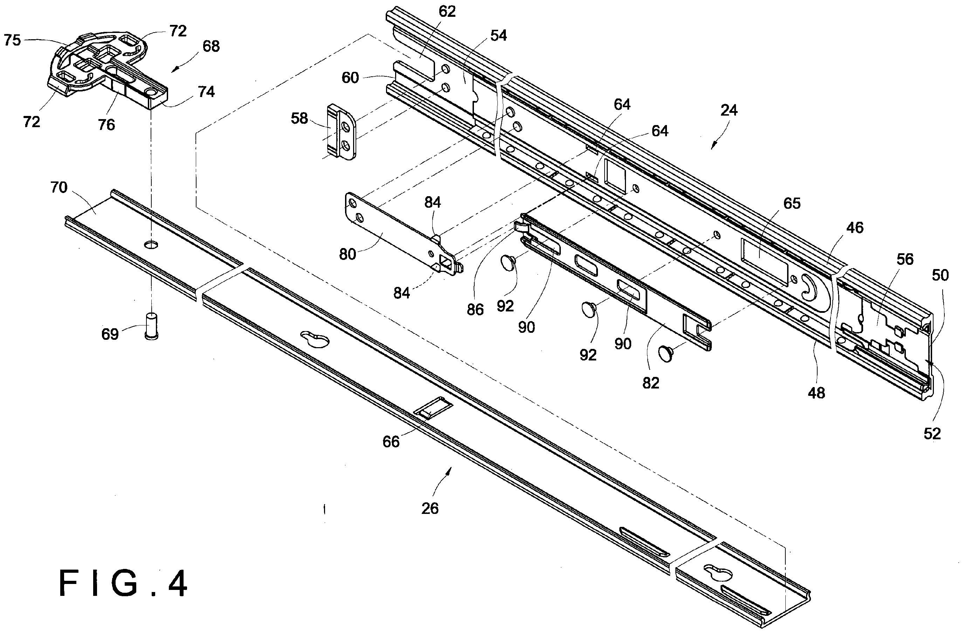

Referring to FIG. 3 and FIG. 4, the first rail 22 includes an upper wall 36, a lower wall 38, and a longitudinal main body 40 extending between the upper wall 36 and the lower wall 38. The upper wall 36, the lower wall 38, and the longitudinal main body 40 jointly define a channel 42. The longitudinal main body 40 is provided with a front blocking portion 43a and a rear blocking portion 43b at its front and rear ends respectively. In addition, a limiting feature 45 is provided between the front blocking portion 43a and the rear blocking portion 43b.

The second rail 24 corresponds to the channel 42 of the first rail 22. The second rail 24 includes an upper wall 46, a lower wall 48, and a longitudinal main body 50 extending between the upper wall 46 and the lower wall 48. The upper wall 46, the lower wall 48, and the longitudinal main body 50 jointly define a channel 52. The longitudinal main body 50 of the second rail 24 includes a first section 54 and a second section 56. The first section 54 is fixedly mounted with a base 58. The first section 54 is further provided with a recess 62 at an end portion 60. In addition, the first section 54 is provided with at least one engaging hole 64 and an aperture 65. In this embodiment, the second section 56 is shorter than the first section 54. In a non-shown embodiment of the present invention, however, the first section 54 and the second section 56 are equivalent in length. The present invention imposes no limitations in this respect.

The third rail 26 is correspondingly mounted to the channel 52 of the second rail 24 and is movably connected to the first section 54 of the second rail 24. The third rail 26 has a limiting feature 66 corresponding to the base 58.

The slide rail assembly 20 further includes a supporting member 68 which is fixedly connected by a fastener 69 to the third rail 26 at a position adjacent to an end portion 70 of the third rail 26. More specifically, the supporting member 68 has a pair of supporting wings 72, a pushing portion 74 between the supporting wings 72, a cushioning portion 75 opposite the pushing portion 74, and at least one engaging section 76 on a lateral side of the pushing portion 74.

The extension rail 28 is correspondingly mounted to the channel 52 of the second rail 24 and is located at the second section 56 of the second rail 24. The extension rail 28 is fixedly mounted to the second section 56 of the second rail 24 via a positioning element 78 so that the second rail 24 can be displaced relative to the first rail 22 by the extension rail 28. It is feasible, however, to mount the extension rail 28 to the second section 56 of the second rail 24 in a different way. For instance, the extension rail 28 can be so mounted that it is displaceable relative to the second rail 24 within a certain limit. Whichever the case may be, the point is for the second rail 24 to be driven by the extension rail 28.

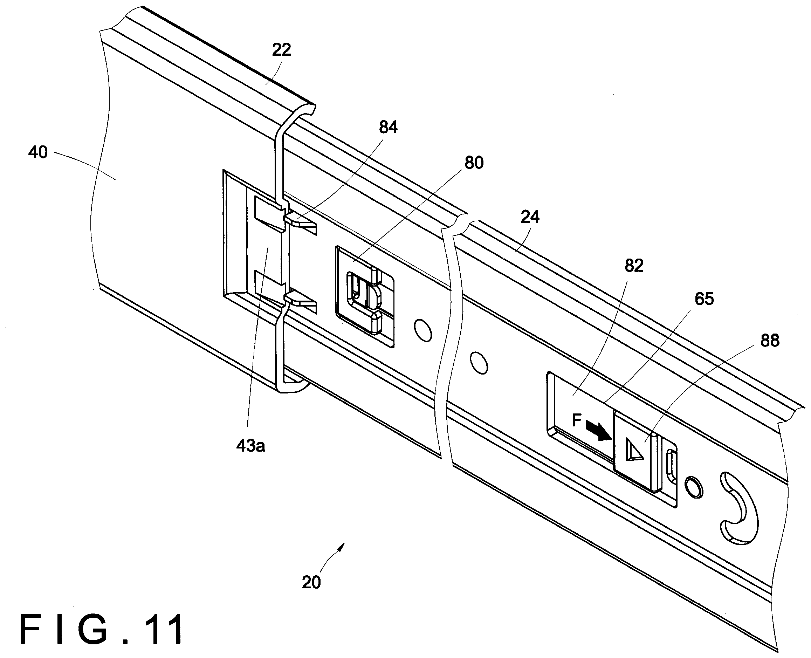

Preferably, the slide rail assembly 20 further includes an engaging member 80 and an operating member 82 operably connected to the engaging member 80. The engaging member 80 is elastically mounted to the first section 54 of the second rail 24. The engaging member 80 has at least one engaging projection 84 corresponding to the engaging hole 64 in the first section 54 of the second rail 24. The operating member 82 is longitudinally movably connected to the first section 54 of the second rail 24. In addition, at least one of the engaging member 80 and the operating member 82 has an inclined projection 86 which is inclined with respect to a longitudinal axis. In this embodiment, the inclined projection 86 is provided on the operating member 82. Preferably, as shown in FIG. 11, the operating member 82 has an operating portion 88 located at the aperture 65 of the second rail 24 to facilitate operation. More specifically, the operating member 82 is provided with at least one slot 90 and a guiding element 92. The guiding element 92 correspondingly passes through the slot 90 and is fixedly connected to the second rail 24 in order for the operating member 82 to be guided by the guiding element 92 and therefore displaced along the longitudinal axis when operated.

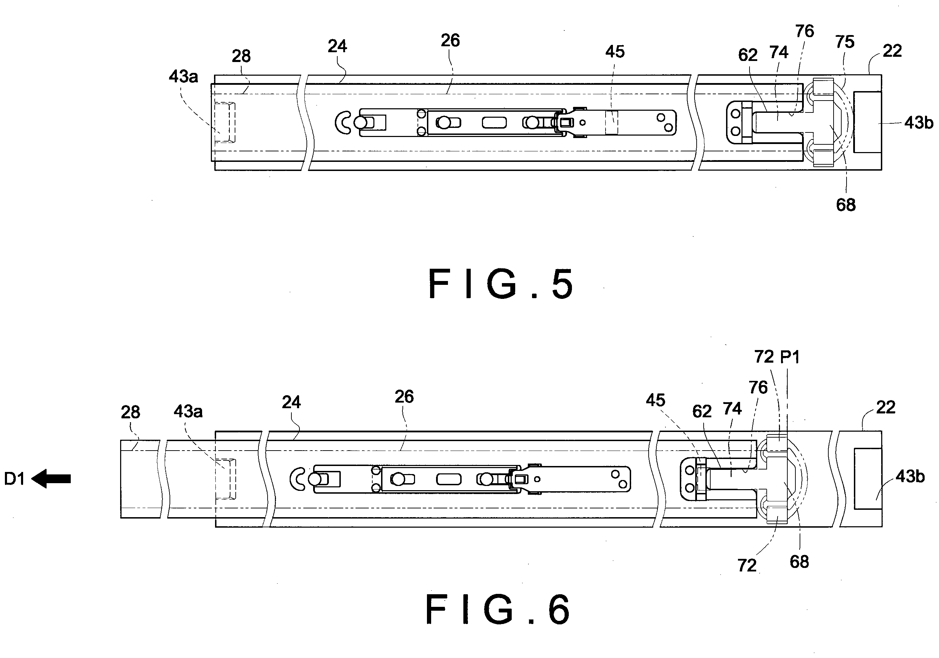

FIG. 5 shows the second rail 24 and the third rail 26 at a retracted position relative to the first rail 22. At this position, the pushing portion 74 of the supporting member 68 is correspondingly inserted in the recess 62 of the second rail 24 while the engaging section 76 of the supporting member 68 is in engaging contact with the periphery of the recess 62 of the second rail 24. In addition, the cushioning portion 75 of the supporting member 68 serves to press against the rear blocking portion 43b of the first rail 22 so as to provide a cushioning effect and reduce the noise of impact when the third rail 26 is displaced to the retracted position relative to the first rail 22.

Referring to FIG. 6, the second rail 24 is pulled in an opening direction D1 via the extension rail 28 so as to reach an extended position. As the second rail 24 is longitudinally displaced relative to the first rail 22, the third rail 26 is driven into longitudinal displacement relative to the first rail 22 by the second rail 24 due to the engaging contact between the engaging section 76 of the supporting member 68 and the periphery of the recess 62 of the second rail 24. Once the third rail 26 is displaced to a first predetermined position P1 relative to the first rail 22, the pushing portion 74 of the supporting member 68 is pressed against the limiting feature 45 of the first rail 22 such that the third rail 26 is retained at the first predetermined position P1. Besides, in the course in which the third rail 26 is displaced relative to the first rail 22, the supporting wings 72 of the supporting member 68 are pressed against the first rail 22 (e.g., the supporting wings 72 being pressed against the upper and lower walls of the first rail 22 respectively) to provide further support.

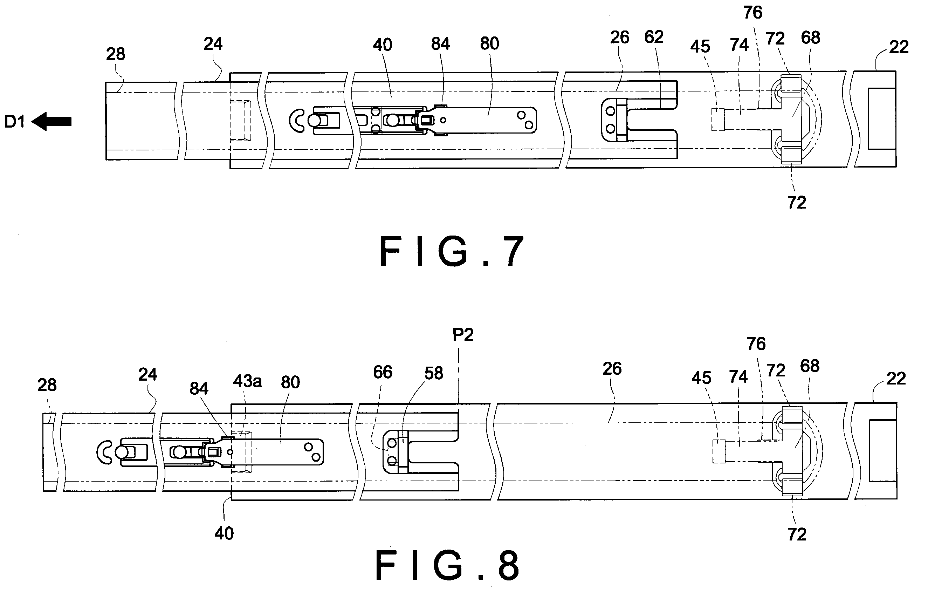

FIG. 7 shows how the recess 62 of the second rail 24 is separated from the engaging section 76 of the supporting member 68 when the second rail 24 is further displaced in the opening direction D1.

In FIG. 8, the second rail 24 has been displaced to a second predetermined position P2 relative to the first rail 22. The base 58 of the second rail 24 is now pressed against the limiting feature 66 of the third rail 26 and thereby retains the second rail 24 at the second predetermined position P2.

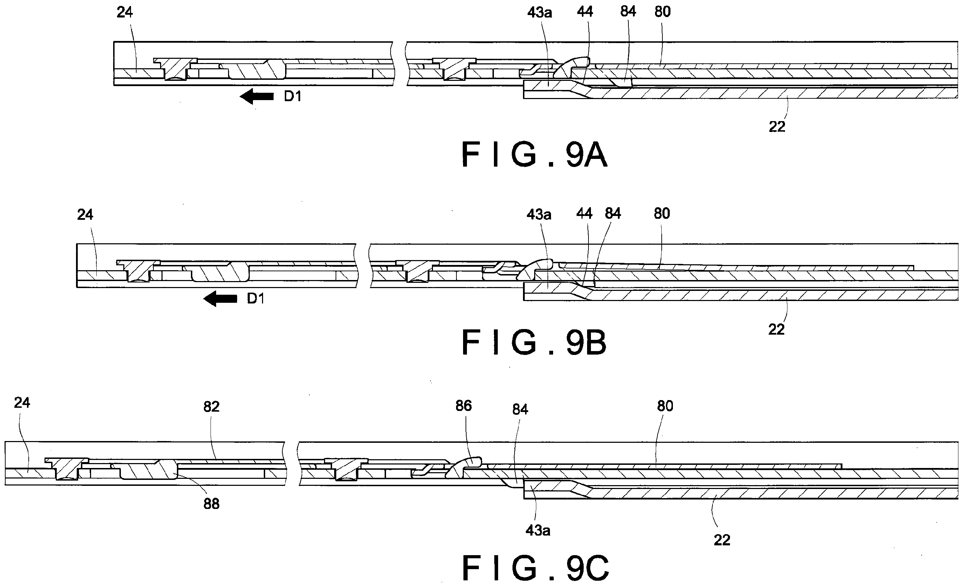

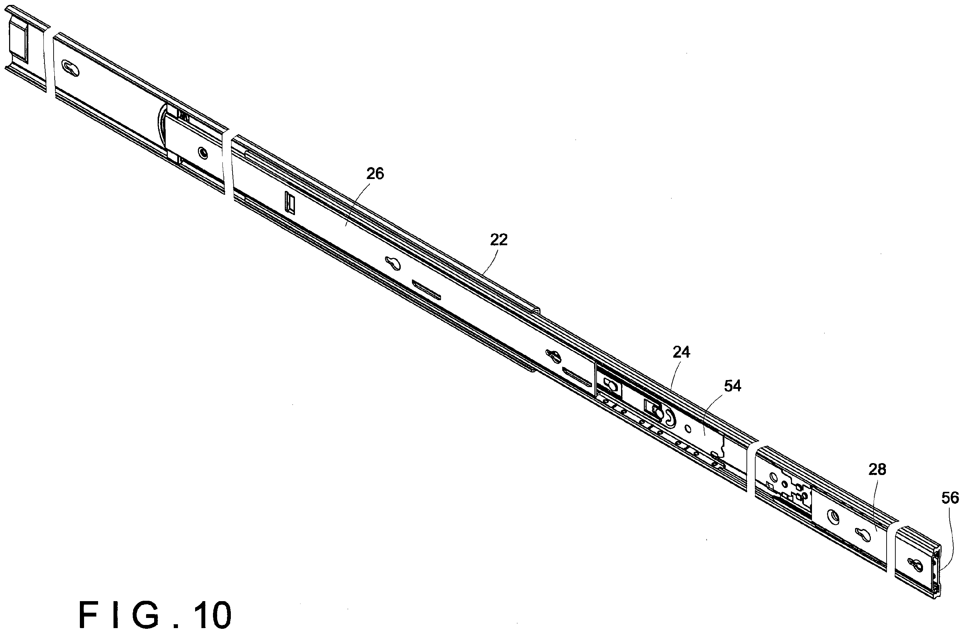

FIG. 9A to FIG. 9C show the process in which the second rail 24 is displaced (i.e., pulled out) relative to the first rail 22. When the engaging projection 84 of the engaging member 80 is displaced to a position corresponding to the front blocking portion 43a of the first rail 22, the engaging projection 84 of the engaging member 80 generates an elastic force in response to contact with an inclined surface 44 of the front blocking portion 43a. Once moved past the front blocking portion 43a of the first rail 22, the engaging projection 84 of the engaging member 80 releases the elastic force and ends up engaged with the front blocking portion 43a of the first rail 22 (i.e., the engaging member 80 being at an engaged position). The slide rail assembly 20 in this state is in an opened position where it is extended to the greatest extent (see FIG. 10).

It can be known from the above that, in the foregoing embodiment of the present invention, the first section 54 and the second section 56 of the second rail 24 are respectively provided with the third rail 26 and the extension rail 28 so as to connect with the first chassis 32 and the second chassis 34 respectively (see FIG. 1). Thereby the second rail 24 can be displaced relative to the first rail 22 by the second chassis 34. Further, the third rail 26 and the extension rail 28 are so designed that they are spaced apart when pulled beyond a predetermined position, thereby solving the problem in the prior art that the complexity of the cables in the chassis of a server and its storage device and the narrow space therein tend to hinder cable disconnection and component replacement.

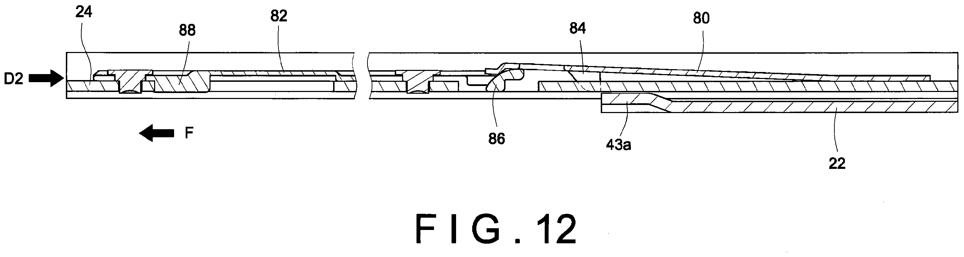

Referring to FIG. 11 and FIG. 12, in order to displace and thereby retract the slide rail assembly 20 in a retracting direction D2 from the aforesaid opened position, a force F is applied to the operating portion 88 of the operating member 82 through the aperture 65 of the second rail 24. As a result, the inclined projection 86 of the operating member 82 pushes the engaging member 80 and thus lifts the engaging projection 84 of the engaging member 80 out of engagement with the front blocking portion 43a of the first rail 22, allowing the second rail 24 and the third rail 26 to be displaced in the retracting direction D2 to the retracted position shown in FIG. 2 and FIG. 5.

While the present invention has been disclosed by way of the preferred embodiments described above, those embodiments are not intended to be restrictive of the invention. The scope of patent protection sought is defined by the appended claims.

## Claims

1. A slide rail assembly (20) applicable to a first chassis (32) and a second chassis (34) comprising:
a first rail (22);
a second rail (24) longitudinally displaceable relative to the first rail (22), the second rail (24) including a first section (54) and a second section (56);
and
a third rail (26) movably connected to the first section (54) of the second rail (24) and longitudinally displaceable relative to the first rail (22) by the second rail (24), and
an extension rail (28) located at the second section (56) of the second rail (24),
wherein the first chassis (32) can be mounted to the third rail (26),
wherein the second chassis (34) can be mounted to the extension rail (28),
wherein the second section (56) of the second rail (24) is connected with the second chassis (34),
wherein the second rail (24) is displaceable relative to the first rail (22) by pulling the second chassis (34), and
thereby the first chassis and the second chassis can be mounted to two rails of the slide rail assembly respectively and be detached one from the other for facilitating maintenance.

2. The slide rail assembly (20) as claimed in claim 1, further including a supporting member (68) connected to the third rail (26), the supporting member (68) having at least one engaging section (76) for making engaging contact with the second rail (24) so that the third rail (26) is longitudinally displaceable relative to the first rail (22) by the second rail (24).

3. The slide rail assembly (20) as claimed in claim 1, wherein the second rail (24) further includes a recess (62), the slide rail assembly (20) further includes a supporting member (68) connected to the third rail (26), and the supporting member (68) has a pushing portion (74) to be inserted into the recess (62).

4. The slide rail assembly (20) as claimed in claim 3 wherein the pushing portion (74) of the supporting member (68) has a side provided with at least one engaging section (76) for making engaging contact with the recess (62) so that the third rail (26) is longitudinally displaceable relative to the first rail (22) by the second rail (24).

5. The slide rail assembly (20) as claimed in claim 3, wherein the supporting member (68) further has a cushioning portion (75) opposite the pushing portion (74), and the first rail (22) further includes a rear blocking portion (43b) so that, when displaced to a retracted position relative to the first rail (22), the third rail (26) is pressed against the rear blocking portion (43b) of the first rail (22) via the cushioning portion (75) of the supporting member (68).

6. The slide rail assembly (20) as claimed in claim 1, further including a supporting member (68) connected to the third rail (26), the supporting member (68) having a pair of supporting wings (72) to be pressed against the first rail (22).

7. The slide rail assembly (20) as claimed in claim 3, wherein the first rail (22) further includes a limiting feature (45) so that, when the third rail (26) has been displaced by the second rail (24) to a first predetermined position (P1) relative to the first rail (22), the pushing portion (74) of the supporting member (68) is pressed against the limiting feature (45) of the first rail (22) and thereby retains the third rail (26) at the first predetermined position (P1).

8. The slide rail assembly (20) as claimed in claim 1, further including a base (58) mounted to the first section (54) of the second rail (24), the third rail (26) further including a limiting feature (66) so that, when the second rail (24) has been displaced to a second predetermined position (P2) relative to the first rail (22), the base (58) of the second rail (24) is pressed against the limiting feature (66) of the third rail (26) and thereby retains the second rail (24) at the second predetermined position (P2).

9. The slide rail assembly (20) as claimed in claim 1, further including an engaging member (80) elastically mounted to the first section (54) of the second rail (24), the engaging member (80) including at least one engaging projection (84), the first rail (22) further including a front blocking portion (43a) so that, when the second rail (24) has been pulled out relative to the first rail (22) to a position, the engaging projection (84) of the engaging member (80) is engaged with the front blocking portion (43a) of the first rail (22).

10. The slide rail assembly (20) as claimed in claim 9, further including an operating member (82) connected to the engaging member (80), the first section (54) of the second rail (24) having an aperture (65), the operating member (82) having an operating portion (88) located at the aperture (65) so that, when the operating portion (88) of the operating member (82) is operated, the engaging projection (84) of the engaging member (80) is disengaged from the first rail (22).

11. The slide rail assembly (20) as claimed in claim 10, wherein at least one of the operating member (82) and the engaging member (80) further has an inclined projection (86) so that, by operating the operating member (82), the inclined projection (86) is driven to push the engaging member (80) and thereby disengage the engaging member (80) from the first rail (22).

12. The slide rail assembly (20) as claimed in claim 11, further including a positioning element (78) for mounting the extension rail (28) to the second section (56) of the second rail (24) so that the second rail (24) is displaceable relative to the first rail (22) via the extension rail (28).

## Patentansprüche

1. Eine Laufschienenmontage (20) für ein erstes Fahrgestell (32) und ein zweites Fahrgestell (34), umfassend:
eine erste Schiene (22);
eine zweite Schiene (24), die der Länge nach in der ersten Schiene (22) verschiebbar ist; die zweite Schiene (24) aus einem ersten Abschnitt (54) und aus einem zweiten Abschnitt (56) besteht; und
eine dritte Schiene (26), die beweglich am ersten Abschnitt (54) der zweiten Schiene (24) befestigt und der Länge nach durch die zweite Schiene (24) in der ersten Schiene (22) verschiebbar ist; und
eine Erweiterungsschiene (28), die am zweiten Abschnitt (56) der zweiten Schiene (24) angeordnet ist,
wobei das erste Fahrgestell (32) an die dritte Schiene (26) montiert werden kann,
wobei das zweite Fahrgestell (34) an die Erweiterungsschiene (28) montiert werden kann,
wobei der zweite Abschnitt (56) der zweiten Schiene (24) am zweiten Fahrgestell (34) befestigt ist,
wobei die zweite Schiene (24) durch Ziehen am zweiten Fahrgestell (34) in der ersten Schiene (22) verschiebbar ist; und
daher das erste Fahrgestell und das zweite Fahrgestell je an eine der beiden Schienen der Laufschienenmontage montiert und zum Erleichtern der Instandhaltung voneinander entfernt werden können.

2. Die Laufschienenmontage (20) nach Anspruch 1, weiter bestehend aus einem Trageglied (68), das an der dritten Schiene (26) befestigt ist; das Trageglied (68) mit mindestens einem Eingriffteil (76) gebildet ist, um mit der zweiten Schiene (24) in Berührung zu kommen, so dass die dritte Schiene (26) der Länge nach durch die zweite Schiene (24) in der ersten Schiene (22) verschiebbar ist.

3. Die Laufschienenmontage (20) nach Anspruch 1, wobei die zweite Schiene (24) weiter eine Vertiefung (62) aufweist; die Laufschienenmontage (20) weiter aus einem Trageglied (68) besteht, das an der dritten Schiene (26) befestigt ist; das Trageglied (68) mit einem in die Vertiefung (62) einzuführenden Schubteil (74) gebildet ist.

4. Die Laufschienenmontage (20) nach Anspruch 3 wobei auf einer Seite des Schubteils (74) des Trageglieds (68) mindestens ein Eingriffteil (76) vorgesehen ist, um mit der Vertiefung (62) so in Eingriff gebracht zu werden, dass die dritte Schiene (26) der Länge nach mit der zweiten Schiene (24) in der ersten Schiene (22) verschiebbar ist.

5. Die Laufschienenmontage (20) nach Anspruch 3, wobei das Trageglied (68) weiter mit einem Dämpferteil (75) gegenüber dem Schubteil (74) gebildet ist; die erste Schiene (22) weiter aus einem hinteren Blockierteil (43b) besteht, damit beim Verschieben in eine eingezogene Position in der ersten Schiene (22) die dritte Schiene (26) durch den Dämpferteil (75) des Trageglieds (68) gegen den hinteren Blockierteil (43b) der ersten Schiene (22) angedrückt wird.

6. Die Laufschienenmontage (20) nach Anspruch 1, weiter bestehend aus einem Trageglied (68), das an der dritten Schiene (26) befestigt ist; das Trageglied (68) ein gegen die erste Schiene (22) anzudrückendes Paar Stützflügel (72) aufweist.

7. Die Laufschienenmontage (20) nach Anspruch 3, wobei die erste Schiene (22) weiter ein beschränkendes Merkmal (45) aufweist, damit beim Verschieben der dritten Schiene (26) mit der zweiten Schiene (24) in eine erste vorbestimmte Position (P1) in der ersten Schiene (22) der Schubteil (74) des Trageglieds (68) gegen das beschränkende Merkmal (45) der ersten Schiene (22) angedrückt wird, wobei dadurch die dritte Schiene (26) in der ersten vorbestimmten Position (P1) behalten wird.

8. Die Laufschienenmontage (20) nach Anspruch 1, weiter bestehend aus einer Basis (58), die am ersten Abschnitt (54) der zweiten Schiene (24) montiert ist; die dritte Schiene (26) weiter ein beschränkendes Merkmal (66) aufweist, damit beim Verschieben der zweiten Schiene (24) in eine zweite vorbestimmte Position (P2) in der ersten Schiene (22) die Basis (58) der zweiten Schiene (24) gegen das beschränkende Merkmal (66) der dritten Schiene (26) angedrückt wird, wobei dadurch die zweite Schiene (24) in der zweiten vorbestimmten Position (P2) behalten wird.

9. Die Laufschienenmontage (20) nach Anspruch 1, weiter bestehend aus einem Eingriffglied (80), das elastisch am ersten Abschnitt (54) der zweiten Schiene (24) montiert ist; das Eingriffglied (80) mindestens einen Eingriffvorsprung (84) aufweist; die erste Schiene (22) weiter aus einem vorderen Blockierteil (43a) besteht, damit beim Herausziehen der zweiten Schiene (24) in der ersten Schiene (22) in eine Position der Eingriffvorsprung (84) des Eingriffglieds (80) mit dem vorderen Blockierteil (43a) der ersten Schiene (22) in Eingriff gebracht wird.

10. Die Laufschienenmontage (20) nach Anspruch 9, weiter bestehend aus einem Betätigungsglied (82), das am Eingriffglied (80) befestigt ist; der erste Abschnitt (54) der zweiten Schiene (24) eine Öffnung (65) aufweist; das Betätigungsglied (82) mit einem Betätigungsteil (88) gebildet ist, das an der Öffnung (65) so angeordnet ist, dass beim Betätigen des Betätigungsteils (88) des Betätigungsglieds (82) der Eingriffvorsprung (84) des Eingriffglieds (80) aus der ersten Schiene (22) ausgerückt wird.

11. Die Laufschienenmontage (20) nach Anspruch 10, wobei mindestens eines der Betätigungsglieder (82) und das Eingriffglied (80) weiter eine schräge Auskragung (86) aufweisen, damit bei der Betätigung des Betätigungsglieds (82) die schräge Auskragung (86) angetrieben wird, um das Eingriffglied (80) anzuschieben und so das Eingriffglied (80) aus der ersten Schiene (22) ausrückt.

12. Die Laufschienenmontage (20) nach Anspruch 11, weiter bestehend aus einem Positionierelement (78) zum Montieren der Erweiterungsschiene (28) an den zweiten Abschnitt (56) der zweiten Schiene (24), damit die zweite Schiene (24) mit der Erweiterungsschiene (28) in der ersten Schiene (22) verschiebbar ist.

## Revendications

1. Ensemble de glissières (20) applicable à un premier châssis (32) et un second châssis (34) **caractérisé par le fait qu'**il comprend :
un premier rail (22) ;
un deuxième rail (24) déplaçable longitudinalement par rapport au premier rail (22), le deuxième rail (24) comprenant une première section (54) et une seconde section (56) ; et
un troisième rail (26) raccordé de manière mobile à la première section (54) du deuxième rail (24) et déplaçable longitudinalement par rapport au premier rail (22) par le deuxième rail (24), et
un rail d'extension (28) situé à la seconde section (56) du deuxième rail (24),
le premier châssis (32) peut être assemblé sur le troisième rail (26),
le second châssis (34) peut être assemblé sur le rail d'extension (28),
la seconde section (56) du deuxième rail (24) est raccordée au second châssis (34),
le deuxième rail (24) est déplaçable par rapport au premier rail (22) en tirant le second châssis (34), et
le premier châssis et le second châssis peuvent par conséquent être assemblés à deux rails de l'ensemble de glissières respectivement et être détachés l'un de l'autre pour faciliter la maintenance.

2. Ensemble de glissières (20) selon la revendication 1, **caractérisé par le fait qu'**il comprend en outre un élément de soutien (68) raccordé au troisième rail (26), l'élément de soutien (68) présentant au moins une section d'engagement (76) pour permettre un contact d'engagement avec le deuxième rail (24) de sorte que le troisième rail (26) est déplaçable longitudinalement par rapport au premier rail (22) par le deuxième rail (24).

3. Ensemble de glissières (20) selon la revendication 1, **caractérisé par le fait que** le deuxième rail (24) comprend en outre un évidement (62), l'ensemble de glissières (20) comprend en outre un élément de soutien (68) raccordé au troisième rail (26), et l'élément de soutien (68) présente une partie de poussée (74) à insérer dans l'évidement (62).

4. Ensemble de glissières (20) selon la revendication 3, **caractérisé par le fait que** la partie de poussée (74) de l'élément de soutien (68) présente un côté comportant au moins une section d'engagement (76) pour permettre un contact d'engagement avec l'évidement (62) de sorte que le troisième rail (26) est déplaçable longitudinalement par rapport au premier rail (22) par le deuxième rail (24).

5. Ensemble de glissières (20) selon la revendication 3, **caractérisé par le fait que** l'élément de soutien (68) présente en outre une partie rembourrée (75) en face de la partie de poussée (74), et le premier rail (22) comprend en outre une partie de blocage arrière (43b) de sorte que, lorsque déplacé vers une position rétractée par rapport au premier rail (22), le troisième rail (26) est pressé contre la partie de blocage arrière (43b) du premier rail (22) via la partie rembourrée (75) de l'élément de soutien (68).

6. Ensemble de glissières (20) selon la revendication 1, **caractérisé par le fait qu'**il comprend en outre un élément de soutien (68) raccordé au troisième rail (26), l'élément de soutien (68) présentant une paire d'aile de soutien (72) à presser contre le premier rail (22).

7. Ensemble de glissières (20) selon la revendication 3, **caractérisé par le fait que** le premier rail (22) comprend en outre un élément limiteur (45) de sorte que, lorsque le troisième rail (26) a été déplacé par le deuxième rail (24) vers une première position prédéterminée (P1) par rapport au premier rail (22), la partie de poussée (74) de l'élément de soutien (68) est pressée contre l'élément limiteur (45) du premier rail (22) et par conséquent retient le troisième rail (26) à la première position prédéterminée (P1).

8. Ensemble de glissières (20) selon la revendication 1, **caractérisé par le fait qu'**il comprend en outre une base (58) assemblée à la première section (54) du deuxième rail (24), le troisième rail (26) comprenant en outre un élément limiteur (66) de sorte que, lorsque le deuxième rail (24) a été déplacé vers une seconde position prédéterminée (P2) par rapport au premier rail (22), la base (58) du deuxième rail (24) est pressée contre l'élément limiteur (66) du troisième rail (26) et par conséquent retient le deuxième rail (24) à la seconde position prédéterminée (P2).

9. Ensemble de glissières (20) selon la revendication 1, **caractérisé par le fait qu'**il comprend en outre un élément d'engagement (80) assemblé de manière élastique sur la première section (54) du deuxième rail (24), l'élément d'engagement (80) comprenant au moins une saillie de prise (84), le premier rail (22) comprenant en outre une partie de blocage avant (43a) de sorte que, lorsque le deuxième rail (24) a été sorti par rapport au premier rail (22) vers une position, la saillie de prise (84) de l'élément d'engagement (80) est engagée avec la partie de blocage avant (43a) du premier rail (22).

10. Ensemble de glissières (20) selon la revendication 9, **caractérisé par le fait qu'**il comprend en outre un élément opérationnel (82) raccordé à l'élément d'engagement (80), la première section (54) du deuxième rail (24) présentant une ouverture (65), l'élément opérationnel (82) présentant une partie opérationnelle (88) située à l'ouverture (65) de sorte que, lorsque la partie opérationnelle (88) de l'élément opérationnel (82) est opérée, la saillie de prise (84) de l'élément d'engagement (80) est désengagée du premier rail (22).

11. Ensemble de glissières (20) selon la revendication 10, **caractérisé par le fait que** au moins l'élément opérationnel (82) ou l'élément d'engagement (80) présente en outre une saillie inclinée (86) de sorte que, en opérant l'élément opérationnel (82), la saillie inclinée (86) est entraînée à pousser l'élément d'engagement (80) et par conséquent désengager l'élément d'engagement (80) du premier rail (22).

12. Ensemble de glissières (20) selon la revendication 11, **caractérisé par le fait qu'**il comprend en outre un élément de positionnement (78) pour assembler le rail d'extension (28) sur la seconde section (56) du deuxième rail (24) de sorte que le deuxième rail (24) est déplaçable par rapport au premier rail (22) via le rail d'extension (28).
